# EUROPEAN PATENT APPLICATION

(11) **EP 2 061 085 A2**
(43) Date of publication of application: **20.05.2009**
(21) Application number: 08169395.4
(22) Date of filing: 19.11.2008
(51) Int. Cl.: H01L 29/78, H01L 29/423, H01L 21/336, H01L 29/417

(54) **Trench gate MOSFET and manufacturing method thereof**

(30) Priority: 19.11.2007 KR 20070118125
(71) Applicant: MagnaChip Semiconductor Ltd., Cheongju-si, Chungbuk 361-728 (KR)
(72) Inventor: Shin, Hyun Kwang, Gumi-si 730-300 (KR); Lee, Oh Hyeong, Deagu 706-034 (KR)
(74) Representative: Collin, Jérôme

(57) **Abstract**

A trench MOSFET including a substrate (100) having an epi layer (110) and a body layer (120) sequentially formed thereon, a trench (131) formed vertically in the central portion of the epi layer and the body layer, a first gate oxide film (132) formed on the inner wall of the trench, a trench bottom oxide film (135) formed by thermal oxidation in the epi layer between the lower surface of the trench and the upper surface of the substrate to have a thickness greater than a thickness of the first gate oxide film and a width greater than a width of the trench, a gate (130) formed in the trench having the first gate oxide film, a second gate oxide film (160) formed on the gate, and a source region (140) formed at both sides of the upper portion of the gate. The trench bottom oxide film reduces the generation of parasitic capacitance between the epi layer corresponding to a drain region and the gate, thereby improving a switching speed.

## Description

### BACKGROUND OF THE INVENTION

### Field of the Invention

The present invention relates to a trench MOSFET (Metal-Oxide Semiconductor Field Effect Transistor) and a manufacturing method thereof, and, particularly, to a trench MOSFET, in which the thickness of a diffusion oxide film located between a lower portion of a gate and an epi layer is selectively increased, thus reducing the generation of parasitic capacitance in an overlap region, thereby improving a switching speed, and to a method of manufacturing the same.

### Description of the Related Art

Generally, a trench MOSFET is a kind of transistor in which a channel is vertically formed and which includes a gate formed in a trench extending downwards between a source and a drain.

Such a trench MOSFET is lined with a thin insulating layer such as an oxide layer, is filled with a conductor such as polysilicon, and permits the flow of low current, thus supplying specific low on-resistance.

Below, with reference to a related drawing, a conventional trench MOSFET is described in detail.

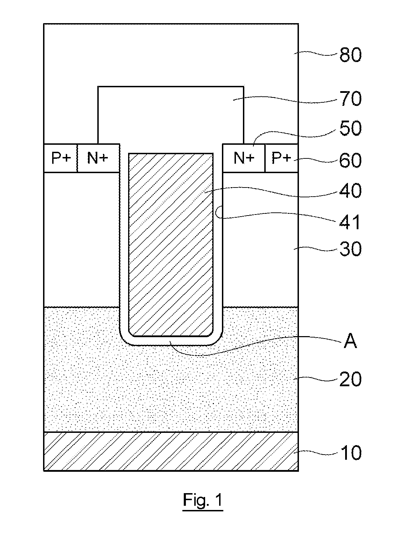

FIG. 1 is a cross-sectional view showing a conventional trench MOSFET.

As shown in FIG. 1, the conventional trench MOSFET includes a substrate 10, an epi layer 20 formed on the substrate 10, and a body layer 30 formed on the epi layer 20 and doped with a dopant having a type opposite that of the epi layer 20. As such, in the central portion of the body layer 30 and the upper portion of the epi layer 20, a trench 41 which is a region for forming a gate is formed to a predetermined thickness.

Provided on the inner wall of the trench 41 is a first gate oxide film A having a thin thickness, and provided also on the first gate oxide film A is a gate 40 which is connected from the body layer 30 to the epi layer 20. Further, a second gate oxide film 70 is formed on the gate 40. Furthermore, a source region 50 and a contact region 60 are formed on the body layer 30, and an upper metal 80 is formed on the second gate oxide film 70, the source region 50 and the contact region 60.

The conventional trench MOSFET thus constructed functions as a switch by electrically connecting or disconnecting the source region 50 and the epi layer corresponding to a drain region in accordance with the on/off of the gate 40.

However, the conventional trench MOSFET has the following problems.

The conventional trench MOSFET includes an overlap region having the thin first gate oxide film A formed between the gate 40 and the epi layer 20. The thin first gate oxide film A plays a role as a parasitic capacitor between the gate 40 and the epi layer 20 corresponding to the drain region, and thus, upon the on/off control of the trench MOSFET, a delay time is increased and a switching speed of the trench MOSFET is decreased, undesirably deteriorating the properties of the trench MOSFET.

Also, as leakage current occurs between the epi layer 20 and the body layer 30 around the trench 41 due to the thin first gate oxide film A, an electric field is increased, undesirably decreasing a breakdown voltage between the body layer 30 and the epi layer 20.

### SUMMARY OF THE INVENTION

Accordingly, the present invention has been devised to solve the problems encountered in the related art, and the present invention provides a trench MOSFET and a manufacturing method thereof, in which the thickness of a diffusion oxide film located between a lower portion of a gate and an epi layer can be selectively increased, thus reducing the generation of parasitic capacitance in an overlap region, ultimately improving a switching speed.

According to the present invention, a trench MOSFET includes a substrate having an epi layer and a body layer sequentially formed thereon; a trench formed vertically in the central portion of the epi layer and the body layer; a first gate oxide film formed on the inner wall of the trench; a diffusion oxide film formed in the epi layer between the lower surface of the trench and the upper surface of the substrate to have a thickness greater than a thickness of the first gate oxide film and a width greater than a width of the trench; a gate formed in the trench having the first gate oxide film; a second gate oxide film formed on the gate; and a source region formed at both sides of the upper portion of the gate, thus reducing the generation of parasitic capacitance between the epi layer corresponding to a drain region and the gate, thereby improving a switching speed.

The center of the upper portion of the diffusion oxide film in contact with the lower portion of the gate may be formed to have a hollow. The diffusion oxide film may have a thickness from 1500 Å to 4000 Å, in particular, from 2000 Å to 2500 Å.

The trench MOSFET may further include an upper metal formed on the exposed surface of the second gate oxide film and the source region, and may also include a high-concentration contact region formed on a portion of the body layer having no source region. The source region may be formed on the body layer, and a high-concentration contact region may be formed on the surface of the upper portion of the body layer having no source region.

The substrate, the epi layer, and the source region may be doped with an N type dopant, the body layer may be doped with a P type dopant, and the contact region may be doped with a high-concentration P+ type dopant. Alternatively, the substrate, the epi layer, and the source region may be doped with a P type dopant, the body layer may be doped with an N type dopant, and the contact region may be doped with a high-concentration N+ type dopant.

In addition, according to the present invention, a method of manufacturing the trench MOSFET includes preparing a substrate having an epi layer and a body layer sequentially formed thereon; forming a first hard mask for forming a trench on the body layer; etching the central portion of the body layer and the upper portion of the epi layer using the first hard mask as an etching mask, thus forming the trench; forming a first gate oxide film and a second hard mask on the inner surface of the trench, etching a bottom of the second hard mask, and then etching the first gate oxide film and the epi layer which are located under the etched second hard mask; subjecting the etched epi layer to thermal oxidation, thus forming a diffusion oxide film having a thickness greater than a thickness of the first gate oxide film and a width greater than a width of the trench; forming a gate in the trench having the diffusion oxide film at a lower portion thereof; and forming a source region and a second gate oxide film on the gate.

The center of the upper portion of the diffusion oxide film in contact with a lower portion of the gate may be formed to have a hollow. The diffusion oxide film may have a thickness from 1500 Å to 4000 Å, in particular, from 2000 Å to 2500 Å.

The method may further include forming an upper metal on the exposed surface of the source region and the second gate oxide film, and may also include forming a high-concentration contact region on a portion of the body layer having no source region. The source region may be formed on the body layer, and the high-concentration contact region may be formed on the surface of the upper portion of the body layer having no source region.

The first hard mask and the second hard mask may be a nitride film or an oxide film, and may be formed through LP-CVD (Low Pressure Chemical Vapor Deposition) or PE-CVD (Plasma Enhanced Chemical Vapor Deposition).

In the method of manufacturing the trench MOSFET, etching the first gate oxide film and the epi layer which are located under the etched second hard mask may be performed by etching the first gate oxide film and then etching the epi layer, or by simultaneously etching the first gate oxide film and the epi layer.

The substrate, the epi layer and the source region may be doped with an N type dopant, the body layer may be doped with a P type dopant, and the contact region may be doped with a high-concentration P+ type dopant. Alternatively, the substrate, the epi layer, and the source region may be doped with a P type dopant, the body layer may be doped with an N type dopant, and the contact region may be doped with a high-concentration N+ type dopant.

### BRIEF DESCRIPTION OF THE DRAWINGS

The features and advantages of the present invention will be more clearly understood from the following detailed description taken in conjunction with the accompanying drawings, in which:
FIG. 1 is a cross-sectional view showing a conventional trench MOSFET;
FIG. 2 is a cross-sectional view showing an N channel trench MOSFET according to a first embodiment of the present invention;
FIGS. 3A to 3J are views sequentially showing a process of manufacturing the N channel trench MOSFET according to the first embodiment of the present invention;
FIG. 4 is a graph showing the capacitance of the N channel trench MOSFET according to the first embodiment of the present invention;
FIG. 5 is a cross-sectional view showing a P channel trench MOSFET according to a modification of the first embodiment of the present invention;
FIG. 6 is a cross-sectional view showing an N channel trench MOSFET according to a second embodiment of the present invention;
FIG. 7 is a cross-sectional view showing a P channel trench MOSFET according to a modification of the second embodiment of the present invention;
FIG. 8 is a cross-sectional view showing an N channel trench MOSFET according to a third embodiment of the present invention; and
FIG. 9 is a cross-sectional view showing a P channel trench MOSFET according to a modification of the third embodiment of the present invention.

### DESCRIPTION OF THE PREFERRED EMBODIMENTS

Hereinafter, a detailed description will be given of the construction and manufacturing method of a trench MOSFET according to preferred embodiments of the present invention and the effects thereof with reference to the accompanying drawings.

### 1^{st} Embodiment

Below, the construction and manufacturing method of a trench MOSFET according to a first embodiment of the present invention are specifically described with reference to the related drawings.

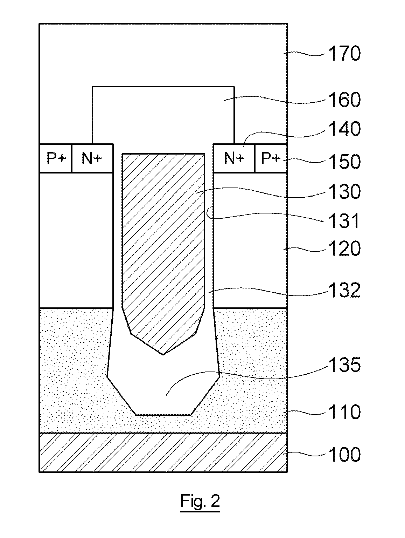

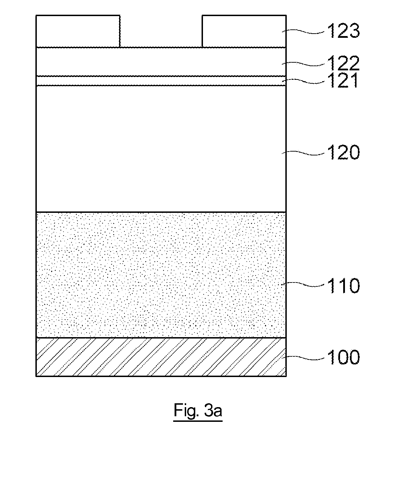

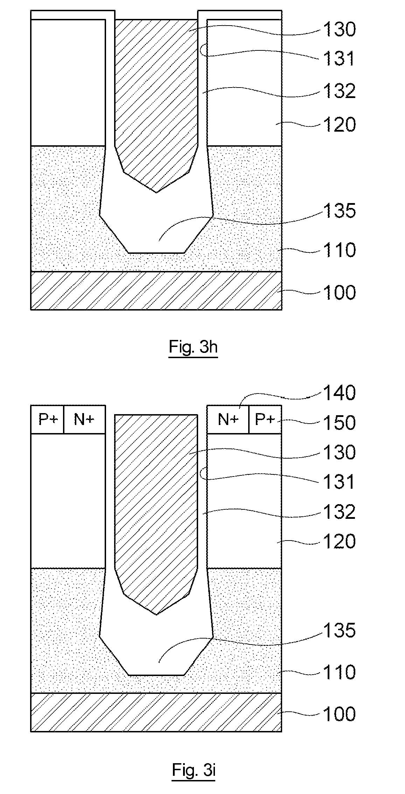

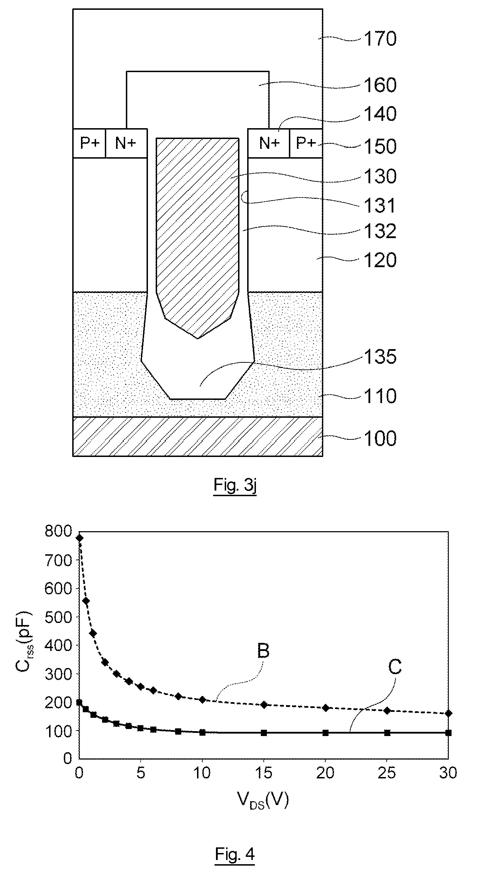

FIG. 2 is a cross-sectional view showing an N channel trench MOSFET according to the first embodiment of the present invention, FIGS. 3A to 3J are views sequentially showing a process of manufacturing the N channel trench MOSFET according to the first embodiment of the present invention, and FIG. 4 is a graph showing the capacitance of the N channel trench MOSFET according to the first embodiment of the present invention.

As shown in FIG. 2, the N channel trench MOSFET according to the present invention includes a substrate 100, an epi layer 110 formed on the substrate 100, and a body layer 120 doped with a type of dopant opposite that of the epi layer 110, a trench 131 vertically formed in the central portion of the epi layer 110 and the body layer 120, a diffusion oxide film 135 formed in the epi layer 110 between the lower surface of the trench 131 and the upper surface of the substrate 100, a first gate oxide film 132 formed thin on the inner wall of the trench 131, a gate 130 formed in the trench 131 having the first gate oxide film 132, a second gate oxide film 160 formed on the gate 130, and a source region formed at both sides of an upper portion of the gate 130.

The substrate 100 is doped with a high-concentration N type dopant to lower the value of the resistance component of the epi layer which is to be a drain region of the trench MOSFET, and is located at the lowest position of the trench MOSFET.

The epi layer 110, which is formed on the substrate 100, is doped with a low-concentration N type dopant to increase a breakdown voltage of the trench MOSFET and is to be a drain region. Provided in the center of the epi layer 110 is the lower portion of the trench 131 having a predetermined depth.

The body layer 120 is formed on the epi layer 110, and has the trench 131 vertically formed in the center thereof. In the case where the gate 130 is in an on-state, the region of the body layer 120 facing the gate 130 is formed with a channel for electrically connecting the source region 140 and the epi layer 110 corresponding to the drain region.

The gate 130 is formed on the first gate oxide film 132 provided on the inner wall of the trench 131, and is on/off controlled in response to a gate voltage applied from the outside, thus electrically connecting or disconnecting the source region 140 and the epi layer 110.

The source region 140 is formed on the body layer 120, corresponding to both sides of the upper portion of the gate 130, and is doped with an N type dopant to electrically connect it with the epi layer 110 corresponding to the drain region. At the side surface of the source region 140, corresponding to the exposed upper region of the body layer 120, a contact region doped with a high-concentration P+ type dopant is provided.

The second gate oxide film 160 is formed on the gate 130 and the source region 140 located at both sides of the upper portion of the gate 130, and the upper metal 170 is formed on the second gate oxide film 160, the source region 140, and the contact region 150, in order to cover the second gate oxide film 160.

The trench MOSFET according to the present invention is advantageous because the diffusion oxide film 135 having a predetermined thickness is formed in the epi layer 110 between the lower surface of the trench 131 and the upper surface of the substrate 100 facing each other, thus reducing the overlap region between the gate 130 and the epi layer 110 corresponding to the drain region, thereby increasing the driving voltage between the gate and the drain.

The diffusion oxide film 135 may be formed to be wider than the trench 131. Also, a hollow is formed in the center of the upper portion of the diffusion oxide film 135 in contact with the gate 130, and the depth of the hollow of the diffusion oxide film 135 may be set so that the center of the hollow does not reach to the lower surface of the diffusion oxide film 135.

As in "C" of FIG. 4 showing the gate-drain capacitance of the trench MOSFET according to the present invention, the trench MOSFET according to the present invention reduces the overlap region between the gate 130 and the epi layer 110 corresponding to the drain region due to the diffusion oxide film 135, thus lowering parasitic capacitance. Thereby, the switching delay time of the trench MOSFET can be decreased, ultimately improving the switching speed. As such, in the graph of FIG. 4, "B" indicates capacitance of a conventional trench MOSFET.

The diffusion oxide film 135 may be formed to have a thickness greater than a thickness of the first gate oxide film 132 provided on the inner wall of the trench 131. If the diffusion oxide film 135 is formed at the same thickness as the thickness of the first gate oxide film 132, it is thin and thus a problem of increasing parasitic capacitance may occur as in the conventional trench MOSFET. In order to prevent the generation of such parasitic capacitance, it is preferred that the diffusion oxide film 132 be formed to a thickness greater than the thickness of the first gate oxide film 132.

The thickness of the diffusion oxide film 135 may be set from 1500 Å to 4000 Å. If the diffusion oxide film 135 is thinner than 1500 Å, it is thin and thus a problem of increasing parasitic capacitance may occur as in the conventional trench MOSFET. Conversely, if the diffusion oxide film 135 is thicker than 4000 Å, it is too thick and thus comes into contact with the substrate 100. So, the thickness of the epi layer 110 should be increased, whereby the total thickness of the trench MOSFET may be increased, undesirably enlarging the size of the trench MOSFET. Therefore, the diffusion oxide film 135 may be formed to a thickness from 1500 Å to 4000 Å, in particular, from 2000 Å to 2500 Å.

The side surface of the diffusion oxide film 135 in contact with the epi layer 110 is not tilted inward the diffusion oxide film 135 but is tilted toward the epi layer 110, namely, outwards. In this way, when the width of the diffusion oxide film 135 is increased, a problem of the conventional trench MOSFET in which leakage current occurs at the point of contact of the first gate oxide film A, the epi layer 10 and the body layer 20 attributable to the thin first gate oxide film A can be prevented, thus increasing the breakdown voltage.

In the method of manufacturing the trench MOSFET thus constructed, as shown in FIG. 3A, the substrate 100 having the epi layer 110 and the body layer 120 formed thereon is prepared.

Then, the substrate 100 thus prepared is subjected to thermal oxidation, thus forming an oxide layer 121 on the body layer 120, after which a first hard mask 122 is applied on the oxide layer 121. The first hard mask 122 may be formed through CVD (Chemical Vapor Deposition), and an example of the first hard mark 122 may include a nitride film or an oxide film. The CVD for forming the first hard mask 122 may be realized through any one selected from among LP-CVD and PE-CVD.

After the formation of the first hard mask 122, a photoresist pattern 123 for forming a trench is formed on the first hard mark 122.

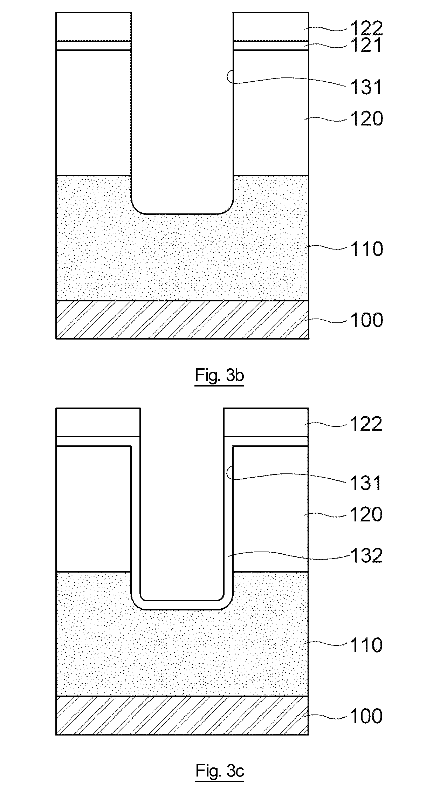

Next, as shown in FIG. 3B, an etching process is performed using the photoresist pattern 123 as an etching mask, thereby etching the first hard mask 122. As the etching process, dry etching may be performed, thus forming the first hard mask 122 and removing the photoresist pattern 123 remaining on the first hard mask 122.

Further, using the etched first hard mask 122 as an etching mask, an etching process is performed, thus sequentially etching the body layer 120 and the epi layer 110 under the region where the first hard mask 122 is etched, thereby forming the trench 131. As the etching process, dry etching may be performed.

Then, a sacrificial oxidation process is performed, thus eliminating plasma damage to the interface of the trench 131 in the etching process and reducing roughness. After the sacrificial oxidation process, wet etching is performed, thus removing the sacrificial oxide film (not shown) formed in the sacrificial oxidation process. After the removal of the sacrificial oxide film, as shown in FIG. 3C, an oxidation process is performed, thus forming the first gate oxide film 132 on the inner surface of the trench 131.

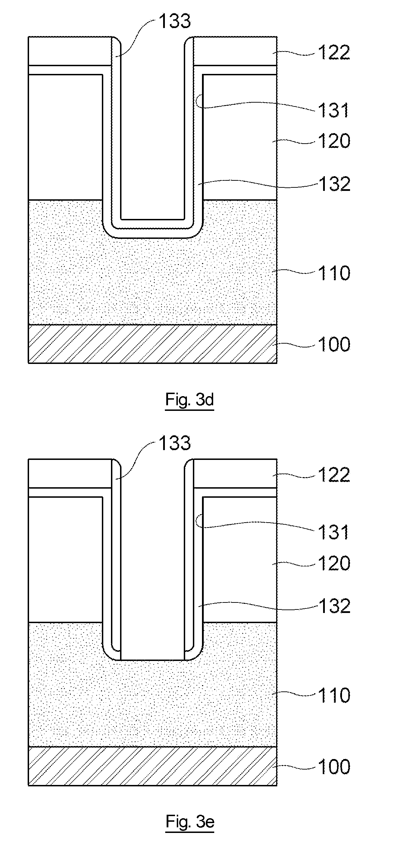

Next, as shown in FIG. 3D, a second hard mask 133 is applied on the first gate oxide film 132, after which the second hard mask 133 applied on a bottom of the trench 131 is removed, as shown in FIG. 3E. The second hard mask 133 may be formed through LP-CVD or PE-CVD, and an example of the second hard mask 133 may include a nitride film or an oxide film.

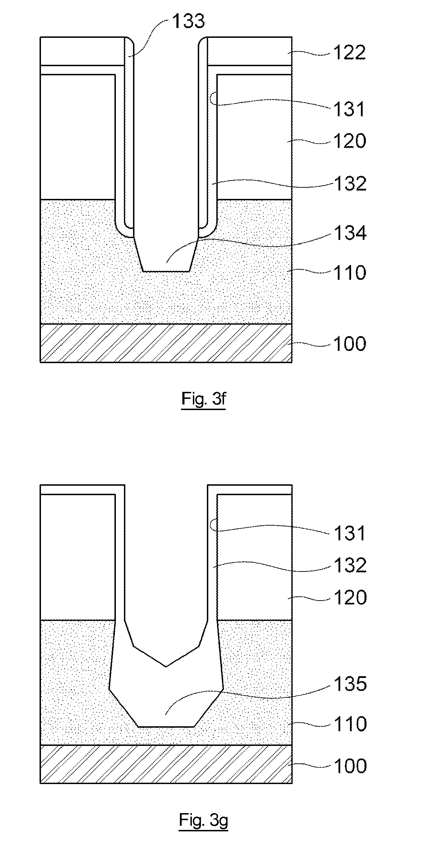

After the removal of the second hard mask 133, the first gate oxide film 132 under the second hard mask 133 is removed. Next, as shown in FIG. 3F, using the removed second hard mask 133 as an etching mask, the epi layer 110 is etched to a predetermined depth.

In the trench MOSFET according to the first embodiment of the present invention, the epi layer 110 located under the first gate oxide film 132 may be removed through two etchings, namely, etching of the trench 131 and etching of the epi layer 110. Thereby, the region for forming the diffusion oxide film 135 which will be described below may be ensured, and thus, the width of the diffusion oxide film 135 may be increased.

In particular, the first gate oxide film 132 and the epi layer 110 under the trench 131 may be separately removed through an independent etching process. Or alternatively, for simplification of the process, the first gate oxide film 132 and the epi layer 110 may be removed at the same time. As such, the removal of the first gate oxide film 132 and the epi layer 110 may be performed through dry etching.

The etched epi layer 110 is subjected to thermal oxidation, thus forming the diffusion oxide film 135 having a thick thickness, as shown in FIG. 3G. Thereafter, the first and second hard masks 122, 133 are removed.

The thermal oxidation process may be performed up to the point of time at which the thickness of the diffusion oxide film 135 is greater than the thickness of the first gate oxide film 132 formed on the inner wall of the trench 131 and the width thereof is greater than the width of the trench 131. If the diffusion oxide film 135 is formed at the same thickness as the thickness of the first gate oxide film 132, it is thin and thus a problem of increasing parasitic capacitance may occur as in the conventional trench MOSFET. In order to prevent such a problem, it is preferred that the diffusion oxide film 135 be formed to be thicker than the first gate oxide film 132.

The thickness of the diffusion oxide film 135 may be set from 1500 Å to 4000 Å. If the diffusion oxide film 135 is formed to be thinner than 1500 Å, it is thin and thus a problem of increasing parasitic capacitance may occur as in the conventional trench MOSFET. Conversely, if the diffusion oxide film 135 is formed to be thicker than 4000 Å, it is too thick and comes into contact with the substrate 100, and thus the thickness of the epi layer 110 should be increased, thereby increasing the total thickness of the trench MOSFET, undesirably resulting in an enlarged trench MOSFET. Therefore, it is preferred that the diffusion oxide film 135 be formed to a thickness from 1500 Å to 4000 Å, in particular, from 2000 Å to 2500 Å.

The upper portion of the diffusion oxide film 135 may have a hollow. The hollow of the diffusion oxide film 135 may be formed so that the center thereof does not reach to the lower surface of the diffusion oxide film 135.

The side surface of the diffusion oxide film 135 in contact with the epi layer 110 is not tilted inward the diffusion oxide film 135 but is tilted toward the epi layer 110, namely, outwards. Accordingly, as the width of the diffusion oxide film 135 may be increased, a problem of the conventional trench MOSFET in which leakage current occurs at the point of contact of the first gate oxide film A, the epi layer 10 and the body layer 20 attributable to the thin first gate oxide film A can be prevented, thus increasing the breakdown voltage.

After the formation of the diffusion oxide film 135, as shown in FIG. 3H, the trench 131 is doped with a material such as polysilicon, thus forming the gate 130. Then, the body layer 120 exposed to the outside, namely, the both sides of the upper portion of the gate 130 are respectively doped with an N type dopant and a high-concentration P+ type dopant, thus forming the source region 140 doped with the N type dopant and the contact region 150 doped with the high-concentration P+ type dopant.

Next, the second gate oxide film 160 is formed so as to cover the gate 130 and a portion of the upper surface of the source region 140, after which the upper metal 170 is formed to cover the upper portion of the second gate oxide film 160 and the upper portion of the contact region 150, thereby forming the trench MOSFET according to the present invention.

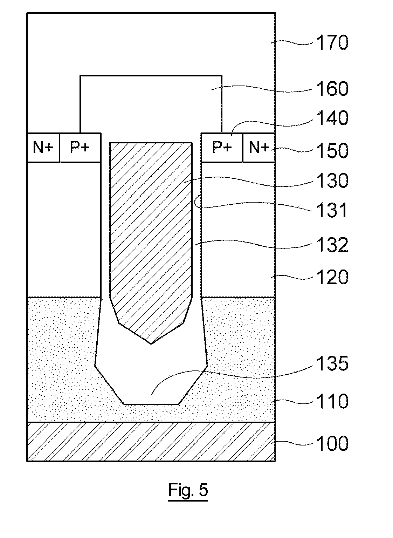

In addition, FIG. 5 illustrates a cross-sectional view of a P channel trench MOSFET which is a modification of the N channel trench MOSFET according to the first embodiment of the present invention. In the P channel trench MOSFET, a substrate 100, an epi layer 110 and a source region 140 are doped with a P type dopant, a body layer 120 is doped with an N type dopant, and a contact region 150 is doped with a high-concentration N+ type dopant.

### 2^{nd} Embodiment

With reference to the related drawings, the construction and manufacturing method of a trench MOSFET according to a second embodiment of the present invention are specifically described. As such, only the construction and manufacturing method according to the second embodiment, which are different from those of the first embodiment, are described, with omission of the description of the same contents.

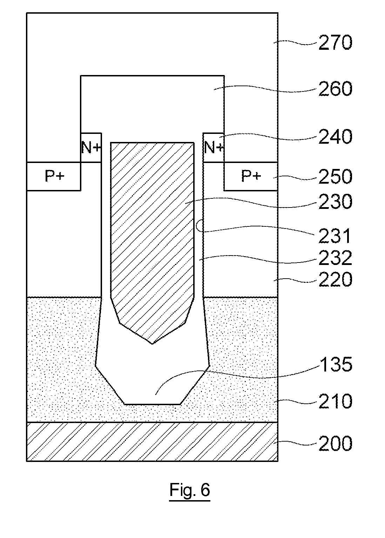

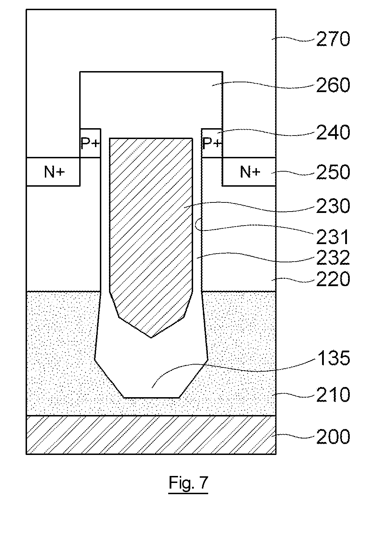

FIG. 6 is a cross-sectional view showing the N channel trench MOSFET according to the second embodiment, and FIG. 7 is a cross-sectional view showing a P channel trench MOSFET according to a modification of the second embodiment.

As shown in FIG. 6, the N channel trench MOSFET according to the second embodiment includes a substrate 200, an epi layer 210 formed on the substrate 200, and a body layer 220 doped with a type of dopant opposite that of the epi layer 210, a trench 231 vertically formed in the central portion of the epi layer 210 and the body layer 220, a diffusion oxide film 135 formed in the epi layer 210 between the lower surface of the trench 231 and the upper surface of the substrate 200, a first gate oxide film 232 and a gate 230 formed in the trench 231, a second gate oxide film 260 formed on the gate 230 and a source region 240, and a contact region 250 formed on the surface of the upper portion of the body layer 220 having no source region 240.

An upper metal 270 is formed on the second gate oxide film 260 and the contact region 250, thereby completing the N channel trench MOSFET according to the second embodiment. As such, the source region 240 is formed on the body layer 220.

The contact region 250 may be formed by etching the upper portion of the body layer 220 having no source region 240 to the same height as that of the source region 240 and then doping a high-concentration P+ type dopant on the etched upper portion of the body layer 220.

In addition, the P channel trench MOSFET which is a modification of the N channel trench MOSFET according to the second embodiment is illustrated in FIG. 7. In such a P channel trench MOSFET, a substrate 200, an epi layer 200 and a source region 240 may be doped with a P type dopant, a body layer 220 may be doped with an N type dopant, and a contact region 250 may be doped with a high-concentration N+ type dopant.

### 3^{rd} Embodiment

With reference to the related drawings, the construction and manufacturing method of a trench MOSFET according to a third embodiment of the present invention are specifically described.

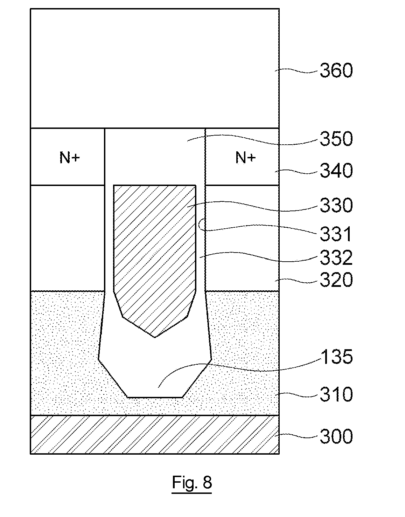

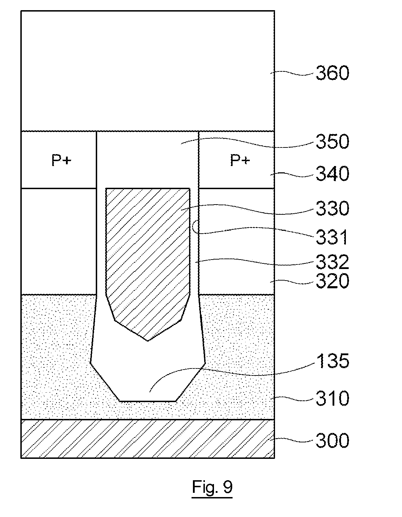

FIG. 8 is a cross-sectional view showing an N channel trench MOSFET according to the third embodiment, and FIG. 9 is a cross-sectional view showing a P channel trench MOSFET according to a modification of the third embodiment.

As shown in FIG. 8, the N channel trench MOSFET according to the third embodiment includes a substrate 300, an epi layer 310 formed on the substrate 300, and a body layer 320 doped with a type of dopant opposite that of the epi layer 310, a trench 331 vertically formed in the central portion of the epi layer 310 and the body layer 320, a diffusion oxide film 135 formed in the epi layer 310 between the lower surface of the trench 331 and the upper surface of the substrate 300, a first gate oxide film 332 and a gate 330 formed in the trench 331, a second gate oxide film 350 formed on the gate 330, and a source region 340 formed at both sides of the second gate oxide film 350.

Further, an upper metal 360 is formed on the second gate oxide film 350 and the source region 340, thereby completing the N channel trench MOSFET according to the third embodiment of the present invention.

In addition, the P channel trench MOSFET which is a modification of the N channel trench MOSFET according to the third embodiment is illustrated in FIG. 9. In such a P channel trench MOSFET, a substrate 300, an epi layer 310 and a source region 340 may be doped with a P type dopant, and a body layer 320 may be doped with an N type dopant.

As described above, the present invention provides a trench MOSFET and a manufacturing method thereof. According to the present invention, the thickness of a first gate oxide film located between a lower portion of a gate and an epi layer can be selectively increased, thus forming a diffusion oxide film having a width greater than a width of a trench. Thereby, the generation of parasitic capacitance between the epi layer corresponding to a drain region and the gate can be reduced, ultimately improving a switching speed.

Also, according to the present invention, a breakdown voltage can be increased due to the diffusion oxide film located between the lower portion of the gate and the epi layer, thus lowering resistivity of the epi layer, thereby decreasing on-resistance.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A trench MOSFET, comprising:
a substrate, having an epi layer and a body layer sequentially formed thereon;
a trench formed vertically in a central portion of the epi layer and the body layer;
a first gate oxide film formed on an inner wall of the trench;
a diffusion oxide film formed in the epi layer between a lower surface of the trench and an upper surface of the substrate to have a thickness greater than a thickness of the first gate oxide film and a width greater than a width of the trench;
a gate formed in the trench having the first gate oxide film;
a second gate oxide film formed on the gate; and
a source region formed at both sides of an upper portion of the gate.

2. The trench MOSFET as set forth in claim 1, wherein a center of an upper portion of the diffusion oxide film in contact with a lower portion of the gate is formed to have a hollow.

3. The trench MOSFET as set forth in claim 1, wherein the diffusion oxide film has a thickness from 1500 Å to 4000 Å.

4. The trench MOSFET as set forth in claim 1 or 3, wherein the diffusion oxide film has a thickness from 2000 Å to 2500 Å.

5. The trench MOSFET as set forth in claim 1, further comprising an upper metal formed on the trench MOSFET having the second gate oxide film and the source region.

6. The trench MOSFET as set forth in claim 1, further comprising a high-concentration contact region formed on a portion of the body layer having no source region.

7. The trench MOSFET as set forth in claim 1, wherein the source region is formed on the body layer, and which further comprises a high-concentration contact region formed on a surface of an upper portion of the body layer having no source region.

8. The trench MOSFET as set forth in claim 6 or 7, further comprising an upper metal formed on the trench MOSFET having the second gate oxide film, the source region, and the contact region.

9. The trench MOSFET as set forth in any one of claims 6 to 8, wherein the substrate, the epi layer, and the source region are doped with an N type dopant, the body layer is doped with a P type dopant, and the contact region is doped with a high-concentration P+ type dopant.

10. The trench MOSFET as set forth in any one of claims 6 to 8, wherein the substrate, the epi layer, and the source region are doped with a P type dopant, the body layer is doped with an N type dopant, and the contact region is doped with a high-concentration N+ type dopant.

11. A method of manufacturing a trench MOSFET, comprising:
- preparing a substrate having an epi layer and a body layer sequentially formed thereon;
- forming a first hard mask for forming a trench on the body layer;
- etching a central portion of the body layer and an upper portion of the epi layer using the first hard mask as an etching mask, thus forming the trench;
- forming a first gate oxide film and a second hard mask on an inner surface of the trench, etching a bottom of the second hard mask, and then etching the first gate oxide film and the epi layer which are located under the etched second hard mask;
- subjecting the etched epi layer to thermal oxidation, thus forming a diffusion oxide film having a thickness greater than a thickness of the first gate oxide film and a width greater than a width of the trench;
- forming a gate in the trench having the diffusion oxide film at a lower portion thereof; and
- forming a second gate oxide film on the gate, and then forming a source region on the body layer.

12. The method as set forth in claim 11, wherein a center of an upper portion of the diffusion oxide film in contact with a lower portion of the gate is formed to have a hollow.

13. The method as set forth in claim 11, wherein the diffusion oxide film has a thickness from 1500 Å to 4000 Å.

14. The method as set forth in claim 11 or 13, wherein the diffusion oxide film has a thickness from 2000 Å to 2500 Å.

15. The method as set forth in claim 11, further comprising forming an upper metal on the trench MOSFET having the source region and the second gate oxide film.

16. The method as set forth in claim 11, further comprising forming a high-concentration contact region on a portion of the body layer having no source region.

17. The method as set forth in claim 11, wherein the source region is formed on the body layer, and which further comprises forming a high-concentration contact region on a surface of an upper portion of the body layer having no source region.

18. The method as set forth in claim 16 or 17, further comprising forming an upper metal on the trench MOSFET having the source region, the second gate oxide film, and the contact region.

19. The method as set forth in claim 11, wherein the first hard mask and the second hard mask are a nitride film or an oxide film.

20. The method as set forth in claim 19, wherein the first hard mask and the second hard mask are formed through low pressure chemical vapor deposition or plasma enhanced chemical vapor deposition.

21. The method as set forth in claim 11, wherein the etching the first gate oxide film and the epi layer which are located under the etched second hard mask is performed by etching the first gate oxide film and then etching the epi layer.

22. The method as set forth in claim 11, wherein the etching the first gate oxide film and the epi layer which are located under the etched second hard mask is performed by simultaneously etching the first gate oxide film and the epi layer.

23. The method as set forth in any one of claims 16 to 18, wherein the substrate, the epi layer and the source region are doped with an N type dopant, the body layer is doped with a P type dopant, and the contact region is doped with a high-concentration P+ type dopant.

24. The method as set forth in claim 16 or 18, wherein the substrate, the epi layer, and the source region are doped with a P type dopant, the body layer is doped with an N type dopant, and the contact region is doped with a high-concentration N+ type dopant.
